# EUROPEAN PATENT APPLICATION

(11) **EP 2 181 755 A2**
(43) Date of publication of application: **05.05.2010**
(21) Application number: 09252484.2
(22) Date of filing: 27.10.2009
(51) Int. Cl.: B01D 53/86, B01D 53/94, C04B 38/00

(54) **Honeycomb structure and reactor using honeycomb structure**

(30) Priority: 31.10.2008 JP 2008281055; 15.10.2009 JP 2009238373
(71) Applicant: NGK INSULATORS, LTD., Nagoya City, Aichi Pref. (JP)
(72) Inventor: Michio Takahashi c/o Legal Affairs and Intellectua, Aichi-ken, 467-8530 (JP); Hiroshi Mizunoi c/o Legal Affairs and Intellectua, Aichi-ken, 467-8530 (JP)
(74) Representative: Paget, Hugh Charles Edward

(57) **Abstract**

There is disclosed a honeycomb structure whose outer peripheral portion is plugged, whereby the insulating properties of the structure itself can improve to further improve the insulating properties, and the temperature of an introduced gas can be raised. Furthermore, when a catalyst is loaded, the loaded catalyst can be activated in an early stage. Especially, also during cold start (the cold start of an engine), the temperature of the introduced gas is easily raised, and the loaded catalyst can easily be activated in the early stage. A plasma reactor is also provided which can generate a large amount of hydrogen and which has a high electrode durability. A honeycomb structure 1 includes a cell structural portion having partition walls 4 which connect one end face thereof to the other end face thereof to define a plurality of cells 3 as through channels of a gas, and cells 3 having plugging portions 9 which plug both the end faces of an outer peripheral portion 7 of the cell structural portion, and the cell area of the plugging portions 9 is 10% or more of the whole cell area.

## Description

### BACKGROUND OF THE INVENTION

### 1. Field of the Invention

The present invention relates to a honeycomb structure and a reactor using a honeycomb structure.

### 2. Description of the Related Art

In recent years, to cope with regulations on an automotive exhaust gas which has been enhanced year by year, a catalyst loading honeycomb structure has been used for removing nitrogen oxides, sulfur oxides, hydrogen chloride, hydrocarbons, carbon monoxide and the like included in the automotive exhaust gas. This cell structure adsorbs and decomposes the above harmful substances included in the automotive exhaust gas by a catalyst loaded in partition walls of the structure, to purify the automotive exhaust gas. In particular, the honeycomb structure is also used as a filter for collecting fine particles discharged from a diesel engine.

Furthermore, in a catalyst loading member using a catalytic function for an internal combustion engine, a boiler, a chemical reactor, a reformer or the like, a filter for collecting fine particles in an exhaust gas (especially a particulate material (PM) in the exhaust gas from the diesel engine) (hereinafter appropriately referred to as "the DPF") or the like, an exhaust gas purifying catalyst having a catalyst metal (a noble metal) on the surface of the honeycomb structure made of a ceramic material is used.

Meanwhile, the above catalyst used in the catalyst loading honeycomb structure usually has a high catalyst activity in a high-temperature region. Therefore, until the temperature of the honeycomb structure rises after the start of the driving of the car, a car is driven with a low catalyst activity, and an insufficiently purified exhaust gas is discharged. Above all, in a low-temperature state during cold start, the catalyst activity cannot sufficiently be exerted, and the insufficiently purified exhaust gas is easily discharged. Therefore, when the internal temperature of the honeycomb structure is raised for a time as short as possible, the purifying treatment efficiency of the catalyst is improved, and this has heretofore been one problem.

Moreover, such a problem similarly applies to a reformer in which the above honeycomb structure is incorporated. That is, the reformer in which the honeycomb structure is incorporated has received attention as eco-friendly clean energy in recent years. However, for example, in the reformer used for the reforming reaction of hydrocarbons or the like, a high temperature of 700 to 900°C is usually necessary for the reforming reaction of hydrocarbons. Therefore, to proceed with the reforming reaction in the reformer, large startup energy or long startup time is necessary. The raising of the internal temperature of the reformer for a time as short as possible is an important problem, because the treatment efficiency of the reformer is noticeably influenced.

To solve such a problem, a method is suggested in which the thicknesses of the partition walls of the honeycomb structure are decreased or the porosities of the partition walls are increased, to decrease the heat capacity of the honeycomb structure or raise the temperature of the honeycomb structure for the short time after the start of the driving of the car. In this method, however, bulk densification due to the decrease of the thicknesses of the partition walls or the increase of the porosities thereof is a cause for lowering the mechanical strength of the honeycomb structure, and this method is an insufficient countermeasure.

Furthermore, heretofore Patent Documents 1 to 3 have been disclosed as follows.

In Patent Document 1, there is disclosed a honeycomb structure whose outer peripheral portion is formed so that a low heat transfer coefficient is obtained and so that the heat of an inner peripheral portion of the honeycomb structure is not easily released, whereby the heat conduction of the inner peripheral portion of the honeycomb structure through the outer peripheral portion thereof is disturbed. However, when such an outer peripheral portion of the honeycomb structure is formed, forming steps increase, and additionally a temperature difference between the outer peripheral portion of the honeycomb structure and the inner peripheral portion thereof is easily made, thereby easily generating cracks due to the temperature difference. That is, the characteristics of the honeycomb structure might be reliable to be deteriorated. Furthermore, sufficient insulating properties cannot be kept, and an only insufficient countermeasure is provided.

In Patent Document 2, there is disclosed an exhaust gas purifying device in which a honeycomb filter for purifying the exhaust gas is a sintered porous ceramic article including a large number of through pores arranged in a longitudinal direction and partition walls for defining the through pores and for functioning as the filter. The honeycomb filter is disposed in a casing connected to an exhaust passage of an internal combustion engine, and a holding seal member is interposed between the honeycomb filter and the casing. The device has a honeycomb structure **characterized in that** the heat transfer coefficient of the holding seal member at 800°C is 0.1 W/m•K or less. However, when such a casing is provided, the number of components is increased, and the forming steps are needlessly increased. In addition, sufficient insulating properties cannot be kept, and this device is an insufficient countermeasure.

In Patent Document 3, a cell structure is disclosed which is provided with an outer wall portion, whereby the mechanical strength of the honeycomb structure is improved, and hence the lowering of the temperature rise speed of a cell structural portion can be suppressed, thereby obtaining a constant evaluation. However, the forming steps increase, a temperature difference between the outer peripheral portion of the structure and the inner peripheral portion thereof is easily made, and the cracks due to the temperature difference are easily generated. Furthermore, in the structure, room for improvement is still left for keeping sufficient insulating properties.

As described above, a sufficient countermeasure is not performed in any one of Patent Documents 1 to 3, the problems have not been solved yet, and a further improvement is demanded.

[Patent Document 1] JP-A-2008-43850
[Patent Document 2] JP-A-2002-70529
[Patent Document 3] JP-A-2005-199179

### SUMMARY OF THE INVENTION

The present invention has been developed in view of the above problems, and an object thereof is to provide a honeycomb structure whose outer peripheral portion is plugged, whereby the insulating properties of the structure itself can increase to improve the insulating properties, and the temperature of an introduced gas can be raised. Furthermore, when a catalyst is loaded, the loaded catalyst can be activated in an early stage. Above all, also during cold start (the cold start of an engine), the temperature of the introduced gas is easily raised, and the loaded catalyst can easily be activated in the early stage.

Above all, the present invention can preferably be used in a plasma reactor.

As a result of concentrated investigations for solving the above problems of a conventional technology, the present inventors have found that the problems are solved by plugging the outer peripheral portion of the honeycomb structure, and have completed the present invention. Specifically, according to the present invention, the following honeycomb structure is provided.

[1] A honeycomb structure comprising: a cell structural portion having partition walls which connect one end face thereof to the other end face thereof to define a plurality of cells as through channels of a gas, and cells having plugging portions which plug both the end faces of an outer peripheral portion of the cell structural portion, wherein the cell area of the plugging portions is 10% or more of the whole cell area.

[2] The honeycomb structure according to [1], wherein the length of each plugging portion in a cell direction is shorter than the whole length of each cell.

[3] The honeycomb structure according to [1] or [2], wherein the length of the plugging portion in the cell direction is 1/6 to 1/3 of the whole length of each cell.

[4] The honeycomb structure according to any one of [1] to [3], whose main component is a ceramic material or a metal material.

[5] The honeycomb structure according to [4], wherein the ceramic material includes silicon carbide.

[6] The honeycomb structure according to any one of [1] to [5], wherein a catalyst is loaded.

[7] A plasma reactor which is provided with a honeycomb electrode using the honeycomb structure according to any one of [1] to [6], the reactor comprising a reforming reactor provided with an introduction port of a gas to be reformed and a discharge port of a reformed gas; a pair of electrodes arranged so as to face each other in an internal space of the reforming reactor; and a pulse source which applies pulse voltages to the pair of electrodes, wherein one of the pair of the electrodes is a linear electrode, and the other electrode thereof is made of a conductive ceramic material.

[8] The plasma reactor according to [7], wherein a catalyst is loaded in the honeycomb structure.

[9] The plasma reactor according to [8], wherein the catalyst is a catalyst which promotes the reforming reaction of the gas to be reformed, and is loaded in the partition walls of the honeycomb electrodes.

[10] The plasma reactor according to [8] or [9], wherein the catalyst is made of a substance containing at least one element selected from the group consisting of a noble metal, aluminum, nickel, zirconium, titanium, cerium, cobalt, manganese, zinc, copper, tin, iron, niobium, magnesium, lanthanum, samarium, bismuth and barium.

[11] The plasma reactor according to any one of [8] to [10], wherein the catalyst is a substance containing at least one element selected from the group consisting of platinum, rhodium, palladium, ruthenium, indium, silver and gold.

[12] The plasma reactor according to any one of [7] to [11], wherein the honeycomb electrode is made of a conductive ceramic material including silicon carbide.

[13] The plasma reactor according to any one of [7] to [12], wherein the honeycomb electrode has a heat transfer coefficient of 10 to 300 W/mK.

[14] The plasma reactor according to any one of [7] to [13], wherein the pulse source is a high voltage pulse source using an electrostatic induction type thyristor.

The honeycomb structure of the present invention can produce excellent effects that the outer peripheral portion of the honeycomb structure can be plugged, whereby the insulating properties of the structure itself can increase to improve the insulating properties and that the temperature of an introduced gas can be raised. Furthermore, when the catalyst is loaded, the loaded catalyst can be activated in an early stage. Above all, also during cold start (the cold start of an engine), the temperature of the introduced gas can easily be raised, and the loaded catalyst can easily be activated in the early stage.

Moreover, when the honeycomb structure is used as the plasma reactor, in addition to the above effect, the excellent startup properties and reaction efficiency of a reforming reaction are obtained.

### BRIEF DESCRIPTION OF THE DRAWINGS

Fig. 1 is a perspective view schematically showing one embodiment of a honeycomb structure of the present invention;
Fig. 2 is a front view schematically showing the honeycomb structure of Fig. 1;
Fig. 3 is a partially omitted diagram schematically showing the section of the honeycomb structure of Fig. 1;
Fig. 4 is a perspective view schematically showing another embodiment of a honeycomb structure of the present invention;
Fig. 5A is a plan view schematically showing the honeycomb structure of Fig. 4;
Fig. 5B is a plan view schematically showing the other embodiment of the honeycomb structure of the present invention in which one cell is added to each cell of the outer peripheral portion of the honeycomb structure of Fig. 5A;
Fig. 6 is a schematic diagram showing that the honeycomb structure of the present invention is attached to a honeycomb structure fixing container;
Fig. 7 is a graph of the outlet temperature of the honeycomb structure; and
Fig. 8 is a perspective view schematically showing one embodiment of a plasma reactor of the present invention. Description of Reference Numerals

1, 1A: honeycomb structure, 3: cell, 4: partition wall, 7: outer peripheral portion, 9: plugging portion, 11: air insulating layer, 13: one end face, 15: other end face, 17: inner peripheral portion, 50: plasma reactor, 52: electrode, 52a: linear electrode, 52b: honeycomb electrode, 54: introduction port, 62: gas to be reformed, 64: pulse source, 66: reformed gas, 68: discharge port, 70: reforming reactor, 76: cell, 81: honeycomb structure fixing container, A: one end face, and B: other end face.

### DESCRIPTION OF THE PREFERRED EMBODIMENT

Hereinafter, embodiments for carrying out a honeycomb structure of the present invention will be described. Additionally, the present invention broadly includes the honeycomb structure provided with the specific matters thereof, and is not limited to the following embodiments.

### [1] Characteristics of Honeycomb Structure of the Present Invention:

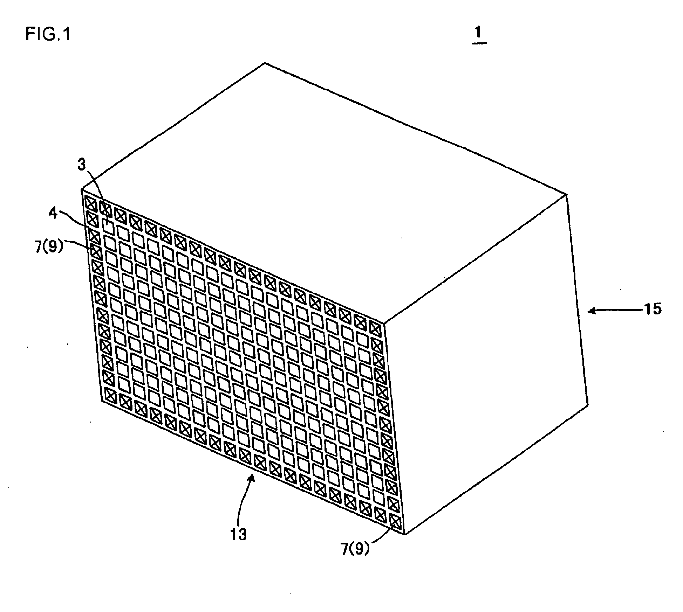

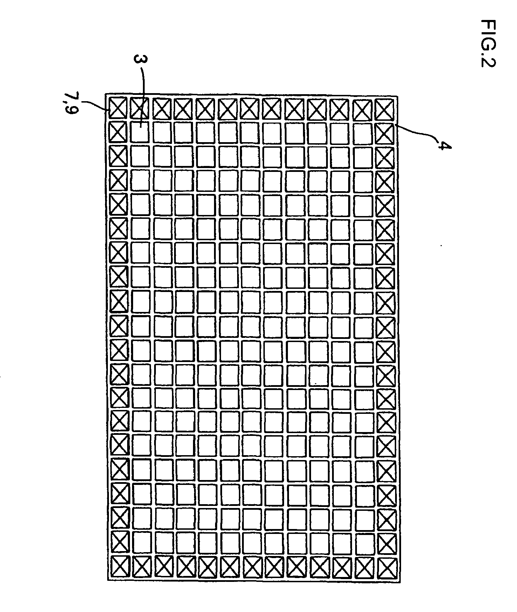

As shown in Figs. 1 and 2, the honeycomb structure of the present invention is a honeycomb structure 1 including a cell structural portion having partition walls 4 which connect one end face thereof to the other end face thereof to define a plurality of cells 3 as through channels of a gas, and the cells 3 having plugging portions 9 which plug both the end faces of an outer peripheral portion 7 of the cell structural portion, wherein the cell area of the plugging portions 9 is 10% or more of the whole cell area.

### [1-1] Outer Peripheral Portion:

As shown in Figs. 1 to 3, the outer peripheral portion 7 of the honeycomb structure 1 of the present embodiment includes the cells 3 formed in the outer peripheral portion 7 of the cell structural portion including the partition walls which define the plurality of cells 3 connecting one end face 13 thereof to the other end face 15 thereof to form the through channels of the gas, and the cells have the plugging portions 9 which plug both the end faces of the outer peripheral portion 7. Thus, the outer peripheral portion 7 of the cell structural portion including the partition walls 4 is provided with the plugging portions 9 to form a so-called air insulating layer in the outer peripheral portion 7. Specifically, when both ends of the cells 3 formed in the outer peripheral portion 7 of the cell structural portion including the partition walls 4 are provided with the plugging portions 9, the inflow/outflow of air in the cells 3 of the outer peripheral portion 7 is easily prevented, and the air in the outer peripheral portion can easily be accumulated in the cells (of the outer peripheral portion). Furthermore, a fluid on the inner side of the outer peripheral portion of the honeycomb structure is not exposed to the outside of the honeycomb structure, but can securely be blocked. Thus, the accumulated air, that is, the air insulating layer is formed on the outer Peripheral Portion of the honeycomb structure. As a result, the fluid is prevented from releasing heat from the inside of the honeycomb structure to the outside thereof. Moreover, the temperature of outside air surrounding the honeycomb structure or the like can be blocked. In other words, the outer portion of the honeycomb structure is provided with an air insulating layer 11 as a block layer interposed between the outer portion of the honeycomb structure and an inner peripheral portion of the honeycomb structure which is a region excluding the outer peripheral portion of the honeycomb structure (a region of the honeycomb structure formed in an axial direction thereof or an inner sectional region of the honeycomb structure excluding the outer peripheral portion thereof in a length direction thereof) as described above. Thus, the outer peripheral portion of the honeycomb structure is provided with the block layer as the air insulating layer, whereby the fluid of an inner peripheral portion 17 as the region of the honeycomb structure excluding the outer peripheral portion thereof is prevented from releasing the heat, and an insulating effect can be produced.

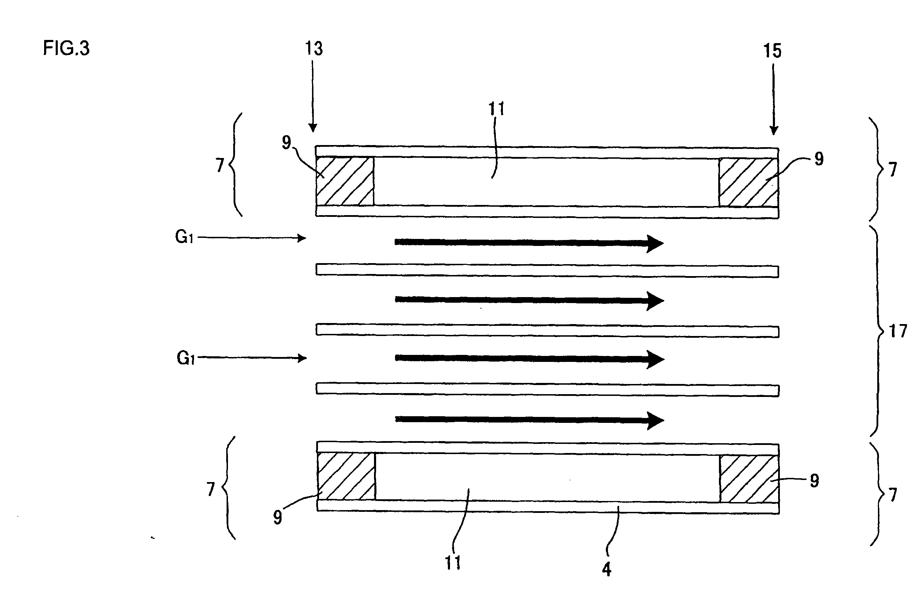

Here, as shown in Fig. 3, "the air insulating layer" is an air layer as an atmosphere in each cell 3 having both ends thereof plugged and closed with the plugging portions 9 (reference numeral 11 of Fig. 3). This air layer performs a function of blocking the heat release of the fluid flowing through the honeycomb structure excluding the outer peripheral portion thereof and blocking the fluid from the temperature of the outside air surrounding the honeycomb structure.

It is to be noted that the plugging portions are formed as described above to easily prevent the inflow/outflow of the air in the cells 3 of the outer peripheral portion 7, but it is not meant that the inflow/outflow of the air in the cells 3 of the outer peripheral portion 7 completely is not performed. In the present embodiment, a large number of pores are formed in the honeycomb partition walls, and hence the air in the outer peripheral portion of the structure flows into the adjacent cells (of the outer peripheral portion) through the pores sometimes.

Moreover, the cell area of the plugging portions formed in this outer peripheral portion is preferably 10% or more of the whole cell area. The cell area of the plugging portions formed in the outer peripheral portion is preferably set to a desired range, whereby the air insulating layer can securely be formed. On the other hand, when the cell area of the plugging portions formed in the outer peripheral portion is smaller than 10% of the whole cell area, the inner peripheral portion of the honeycomb structure excluding the outer peripheral portion thereof unfavorably cannot sufficiently be insulated from the outside of the honeycomb structure by the air insulating layer formed in the outer peripheral portion thereof. The cell area of the plugging portions formed in the outer peripheral portion is more preferably in a range of 10 to 20% of the whole cell area. When the plugging portions are regulated and formed in the outer peripheral portion so as to preferably obtain the cell area in such a desired range, the regeneration efficiency or reforming efficiency of the whole honeycomb structure is not decreased, but the insulating effect can preferably be produced.

For example, in a case where the honeycomb structure has a rectangular parallelepiped shape with a vertical dimension of 20 mm, a lateral dimension of 30 mm and a length of 30 mm and one cell of the outer peripheral portion of the structure is plugged, the cell area of the plugging portions is about 10%. When two cells of the outer peripheral portion are plugged, the cell area is about 20%. However, the present invention is not limited to this example.

Specifically, as shown in Figs. 1 to 3, both the ends of the outer peripheral portion 7 are provided with the plugging portions 9 in the honeycomb structure 1 as the example. It is to be noted that the outer peripheral portion is not limited to the only cells arranged in the most outer periphery of the structure (the most outer peripheral cells) as shown in Figs. 1 to 3, and the outer peripheral portion includes two or three cell rows from the most outer periphery. Thus, the outer peripheral portion is preferably appropriately determined as required in accordance with the dimension, shape or the like of the honeycomb structure. In addition, the area of the outer peripheral portion is preferably a desired area with respect to the whole cell area as described above. However, the most outer peripheral cells need to be provided with at least the plugging portions.

It is to be noted that when the area of the plugging portions formed in the outer peripheral portion is excessively large with respect to the whole area, a purifying efficiency is unfavorably lowered. Furthermore, when the area of the plugging portions formed in the outer peripheral portion is excessively small with respect to the whole area, the insulating effect unfavorably cannot sufficiently be exerted.

Moreover, the length of each plugging portion in a cell direction is preferably shorter than the whole length of each cell, and is more preferably 1/6 to 1/3 of the whole cell length. That is, in the outer peripheral portion of the honeycomb structure of the present embodiment, the length of each of the plugging portions formed in both the end faces of the outer peripheral portion of the cell structural portion is short as compared with the whole length of the structure in the cell direction, whereby an air layer can be formed so that the layer is sandwiched between the plugging portions formed in both the ends of each cell, and the air layer can be the so-called air insulating layer. More preferably, the length of each plugging portion in the cell direction is 1/6 to 1/3 of the whole length of each cell, and the total length of the plugging portions at both the ends is further preferably 1/3 to 2/3. According to such a constitution, the air insulating layer formed between both the end faces of the outer peripheral portion of the cell structural portion can form a desired region. In other words, the length of the air insulating layer is that of the desired region, whereby the inside of the honeycomb structure can be so-called covered with the air insulating layer, and the insulating effect can be improved. Therefore, the temperature in the honeycomb structure can easily be raised, and additionally the heat can be prevented from being released externally from the honeycomb structure. Thus, the effect of the present invention can further be produced.

Here, "the length of the plugging portion in the cell direction" is the length of the plugging portion in the length direction of the honeycomb structure (the axial direction of the honeycomb structure), and "the whole length of the cell" is the whole length of each cell (one cell) formed in the length direction of the honeycomb structure.

For example, in the honeycomb structure having the rectangular parallelepiped shape with a vertical dimension of 20 mm, a lateral dimension of 30 mm and a length of 30 mm, the length of the plugging portion in the cell direction is set to a length (a depth) of about 5 mm to 10 mm from each of both the end faces of the honeycomb structure.

Specifically, as shown in Fig. 3, the length of the plugging portion in the cell direction is the length of the plugging portion 9 with respect to the length direction of the plurality of cells 3 which connect one end face 13 to the other end face 15 to form the through channels of the gas.

Moreover, the main component of the honeycomb structure is preferably a ceramic material or a metal material.

More preferably, the ceramic material includes silicon carbide.

### [1-2] Constitution of Another Honeycomb Structure:

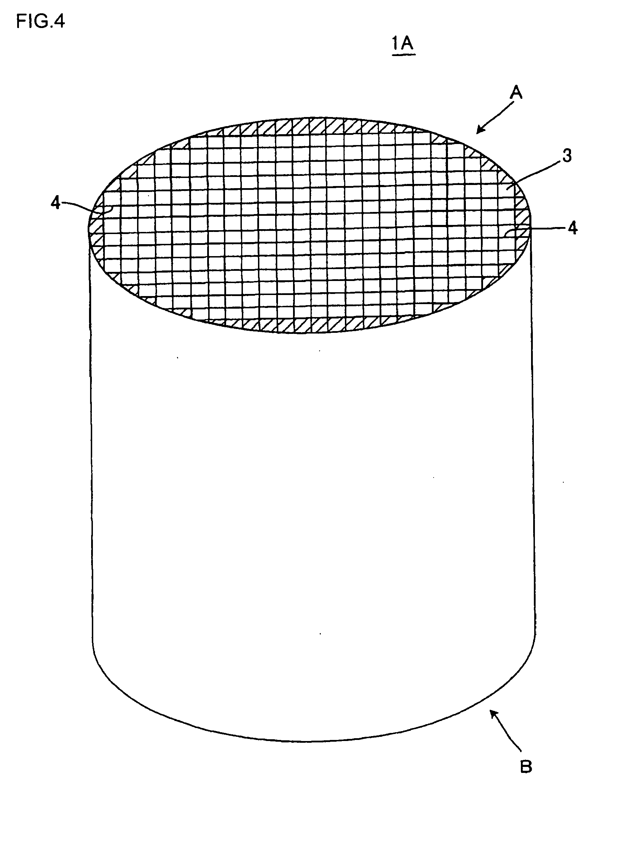

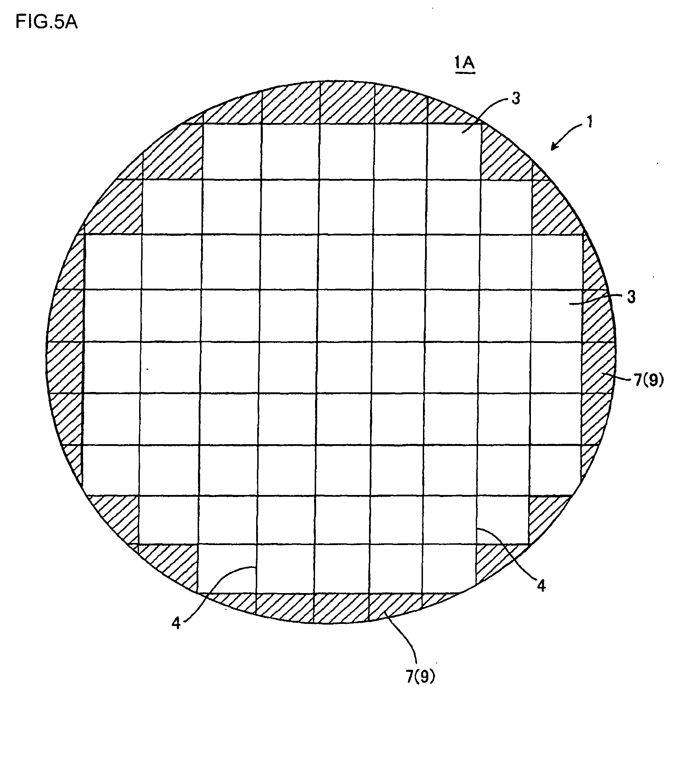

As shown in Figs. 1 to 3, the honeycomb structure of the present embodiment is formed so that an exhaust gas can pass through the structure from the one end 13 thereof to the other end 15 thereof. The honeycomb structure 1 shown in Figs. 1 to 3 is a honeycomb structure having a quadrangular post-like shape, but the shape of the structure is not limited to this shape, and the honeycomb structure may have another shape such as a cylindrical shape as shown in Figs. 4 and 5A. As a material, in consideration of a use environment, a ceramic material having an excellent heat resistance is preferably used, and silicon carbide having heat transfer properties is especially preferable.

Examples of a honeycomb structure having a shape other than the quadrangular post-like shape include a honeycomb structure 1A having a columnar shape as shown in Figs. 4 and 5A. The honeycomb structure is provided with plugging portions for plugging cells of an outer peripheral portion thereof, and includes a cell structural portion having partition walls 4 connecting one end face A thereof to the other end face B thereof to define a plurality of cells 3 as through channels of a gas, and cells 3 having plugging portions 9 which plug both the end faces of an outer peripheral portion 7 of the cell structural portion, and the cell area of the plugging portions 9 is 10% or more of the whole cell area.

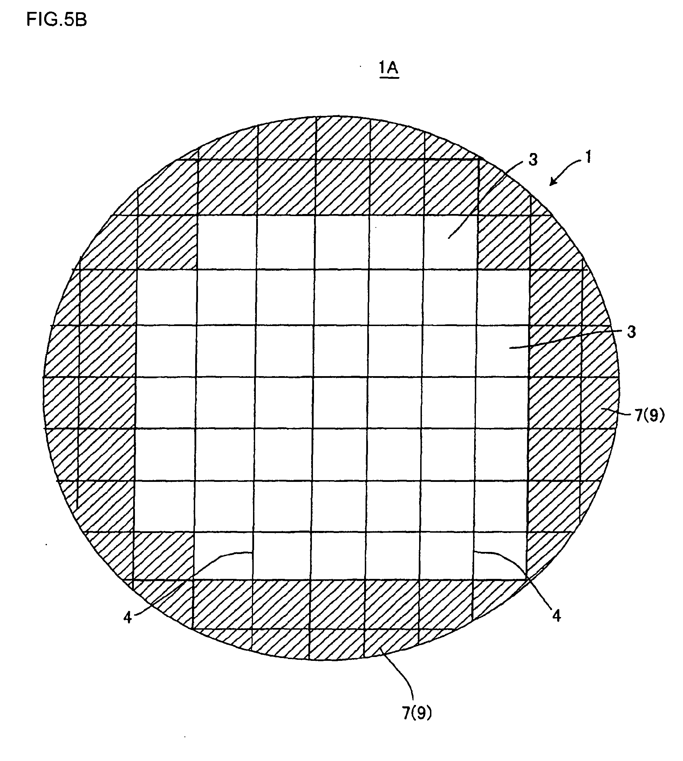

It is to be noted that in a case where a honeycomb structure having a shape shown in Fig. 5A is formed as the honeycomb structure having the shape other than the quadrangular post-like shape, for example, the honeycomb structure shown in Fig. 5A may be provided with an outer peripheral portion including another plugging portion for another cell as shown in Fig. 5B. Also in the desired honeycomb structure having the shape other than the quadrangular post-like shape, it is possible to produce an effect of securing air insulation as one of preferable configurations.

Moreover, when the honeycomb structure of the present embodiment is used as a reformer, the honeycomb structure preferably includes, for example, an insulating honeycomb member provided with a plurality of cells which are defined as through channels of a gas by partition walls, a conductive honeycomb member disposed in the insulating honeycomb member so that the heat can be transferred, an electric discharge electrode disposed so as to face the conductive honeycomb member, thereby forming a pair of electrodes together with the conductive honeycomb member, and a pulse source which applies a pulse voltage to the pair of electrodes.

However, the whole conductive honeycomb member is not necessarily made of silicon carbide. That is, in the present invention, the conductive honeycomb member is preferably made of a conductive ceramic material including silicon carbide. Physical properties are preferably a volume resistance of 1×10⁶ Ωcm or less and a heat transfer coefficient of 300 w/mk or less at room temperature, but the present invention is not limited to this example.

### [1-2-1] Honeycomb Structure and Cell Density:

There is not any special restriction on the honeycomb structure of the present embodiment as long as the structure is a so-called honeycomb structure including a plurality of cells defined as through channels of a gas by partition walls. For example, as a cell shape, a desired shape may appropriately be selected from a circular shape, an elliptic shape, a polygonal shape such as a triangular shape or a quadrangular shape and the like. Moreover, when the honeycomb structure of the present embodiment is used as, for example, a reformer, the desired shape may appropriately be selected in accordance with the cell shape of the insulating honeycomb member. Additionally, the shape of the honeycomb structure is more preferably adapted to the cell shape of the insulating honeycomb member. There is not any special restriction on the cell density (i.e., the number of cells per unit sectional area) of the conductive honeycomb member, and the cell density may appropriately be set in accordance with a purpose, but may be set to a cell density equal to that of the insulating honeycomb member. In this case, the cell density is preferably in a range of 25 to 2000 cells/square inch (4 to 320 cells/cm²). When the cell density is smaller than 25 cells/square inch, the strength of the partition walls, that is, the strength and valid geometric surface area (GSA) of the conductive honeycomb member itself might run short. On the other hand, when the cell density exceeds 2000 cells/square inch, a pressure loss during the flowing of the exhaust gas might increase.

Moreover, there is not any special restriction on the length of the honeycomb structure (the length of the structure in the flow direction of the fluid (the gas)). However, when the honeycomb structure of the present embodiment is used for, for example, a reformer or the like, the length of the structure is preferably 5 to 40% (= the length of the conductive honeycomb member/the length of the insulating honeycomb member), further preferably 10 to 30% of the length of the insulating honeycomb member (the length in the gas flow direction). When the length is shorter than 5%, the amount of the heat transferred from the conductive honeycomb member to the insulating honeycomb member is small. In consequence, the temperature rise of the insulating honeycomb member itself is small, and the effect of the ignition of a catalyst becomes insufficient on occasion. On the other hand, when the length is longer than 40%, the volume ratio of the conductive honeycomb member in the honeycomb structure increases as compared with the insulating honeycomb member, and the exhaust gas purifying function of the insulating honeycomb member might deteriorate.

### [1-3] Catalyst:

Moreover, the catalyst is preferably loaded in the honeycomb structure. In this case, when the honeycomb structure of the present embodiment is used for the function of purifying the exhaust gas, or the reformer, the structure can perform a part of a function of efficiently purifying the exhaust gas by a complex reaction between a plasma and the catalyst. A loading catalyst metal preferably contains at least one element selected from the group consisting of noble metals (platinum, rhodium, palladium, ruthenium, indium, silver and gold), aluminum, nickel, zirconium, titanium, cerium, cobalt, manganese, zinc, copper, tin, iron, niobium, magnesium, lanthanum, samarium, bismuth and barium. The material may be a metal, an oxide or another compound. Moreover, a catalyst metal loading member preferably contains at least one selected from the group consisting of alumina, ceria and zirconia.

The loading amount of the catalyst (the catalyst metal + the loading member) loaded in the honeycomb structure is preferably 10 to 400 g/L. The amount of the catalyst made of the noble metal is further preferably 0.1 to 5 g/L. When the loading amount of the catalyst (the catalyst metal + the loading member) is less than 10 g/L, the catalytic function might not easily be developed. On the other hand, when the amount exceeds 400 g/L, a pressure loss might increase, and additionally a manufacturing cost might increase.

### [1-4] Manufacturing Method:

The honeycomb structure of the present invention can be manufactured as follows. The honeycomb structure is obtained by a heretofore known extrusion method. Specifically, a clay including ceramic powder is extruded into a desired shape, dried and fired to obtain the honeycomb structure having a honeycomb shape. In this case, silicon carbide or the like is used as a ceramic material.

The catalyst is loaded in the partition walls of the honeycomb structure as required. An aqueous solution including catalyst components is beforehand infiltrated into the ceramic powder as the fine particles of the loading member, followed by drying and firing, thereby obtaining the fine particles coated with the catalyst. A dispersion medium (water or the like) or another additive is added to the fine particles coated with the catalyst, to prepare a coating solution (the slurry), and the partition walls of the honeycomb structure are coated with the slurry, dried and fired, whereby the catalyst is loaded in the partition walls of the honeycomb structure.

### [2] Plasma Reactor:

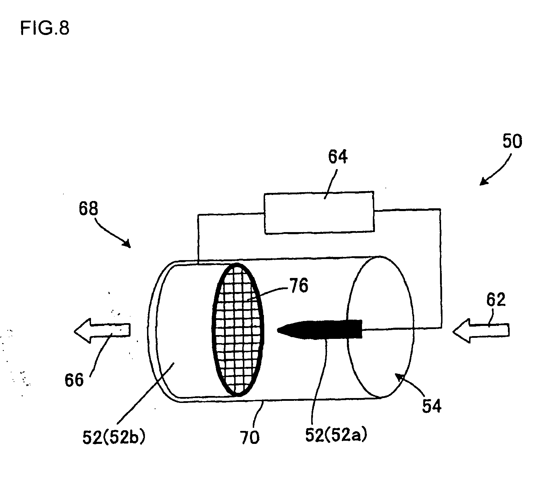

As another embodiment of the present invention, a plasma reactor using the above honeycomb structure is provided. Specifically, as in a plasma reactor shown in Fig. 8, a plasma reactor 50 includes a honeycomb electrode 52b using the above honeycomb structure, and includes a reforming reactor 70 provided with an introduction port 54 of a gas 62 to be reformed and a discharge port 68 of a reformed gas 66, a pair of electrodes 52 arranged so as to face each other in an internal space of the reforming reactor 70, and a pulse source 64 which applies a pulse voltage to the pair of electrodes 52. The plasma reactor 50 is **characterized in that** one of the pair of electrodes is a linear electrode 52a, and the other electrode is made of a conductive ceramic material.

### [2-1] Constituent Members of Plasma Reactor:

Examples of constituent members of the plasma reactor of the present invention include a honeycomb electrode, a linear electrode, a catalyst, a reforming reactor, a pulse source and the like.

### [2-1-1] Honeycomb Electrode:

In the plasma reactor of the present invention, a pair of electrodes are arranged so as to face each other in the internal space of the reforming reactor. The "honeycomb electrode" mentioned in the present specification is an electrode having a honeycomb structure made of a conductive ceramic material and including a plurality of cells which are defined by partition walls and which become through channels of a gas.

There is not any special restriction on the structure of the honeycomb electrode as long as the structure is a so-called honeycomb structure including the plurality of cells which are defined by the partition walls and which become the through channels of the gas. For example, as a cell shape, a desired shape may appropriately be selected from a circular shape, an elliptic shape, a polygonal shape such as a triangular shape or a quadrangular shape and the like.

In the present invention, there is not any special restriction on the cell density (i.e., the number of the cells per unit sectional area) of the honeycomb electrode, and the cell density may appropriately be designed in accordance with a purpose, but is preferably in a range of 6 to 2000 cells/square inch (1.0 to 320 cells/cm²). When the cell density is smaller than 6 cells/square inch, the strength of the partition walls, that is, the strength and valid geometric surface area (GSA) of the honeycomb electrode itself might run short. On the other hand, when the cell density exceeds 2000 cells/square inch, a pressure loss during the flowing of the gas to be reformed might increase.

In particular, when the honeycomb electrode is used for reforming hydrocarbons to generate hydrogen, the cell density of the honeycomb electrode is preferably 25 to 1163 cells/square inch (4 to 186 cells/cm²). When the cell density is less than 4 cells/cm², the generation region of plasmas which discharge electricity along the surfaces of the partition walls of the cells becomes coarse, and the reforming efficiency of the gas to be reformed decreases on occasion. On the other hand, when the cell density exceeds 186 cells/cm², the back pressure resistance of the honeycomb structure increases sometimes.

Moreover, the thicknesses of the partition walls (the wall thicknesses) may appropriately be designed in accordance with the purpose, and there is not any special restriction on the thicknesses. When the honeycomb electrode is used, for example, for reforming hydrocarbons to generate hydrogen, the wall thicknesses are preferably 50 µm to 2 mm, further preferably 60 µm to 500 µm. When the wall thicknesses are less than 50 µm, the mechanical strength of the partition walls lowers, and the walls break down owing to shock, or heat stress due to temperature change sometimes. On the other hand, when the wall thicknesses exceed 2 mm, the ratio of cell volumes in the honeycomb electrode decreases, and a defect might be generated that the pressure loss during the permeation of the gas to be reformed excessively increases.

Furthermore, the length of the honeycomb electrode (the length thereof in the flow direction of the gas) is preferably 5 mm to 40 mm, further preferably 10 mm to 30 mm. When the length is shorter than 5 mm, the plasma generation region due to the surface discharge is excessively small, and a large part of hydrocarbons included in the gas to be reformed is not reformed and is discharged from the reforming reactor as it is. On the other hand, when the length is longer than 40 mm, a large amount of power for generating the plasmas is necessary. Additionally, the whole plasma reactor is enlarged, and becomes inappropriate for the application of a car-mounted fuel reformer or the like which is required to be small-sized and lightweight.

As "the conductive ceramic material" of the honeycomb electrode, silicon carbide is preferable. However, when the honeycomb electrode has conductivity, the whole electrode does not have to be necessarily made of silicon carbide. That is, in the plasma reactor of the present invention, the honeycomb electrode is preferably made of the conductive ceramic material including silicon carbide. In this case, the content of silicon carbide in the honeycomb electrode is preferably 50 mass% or more, further preferably 60 mass% or more in order to suppress the decrease of the conductivity.

Moreover, the honeycomb electrode is preferably a porous member having a porosity of 30 to 60%, further preferably 40 to 50%. When the porosity is less than 30%, the effect of micro electric discharge in gaps among ceramic particles might decrease. On the other hand, when the porosity exceeds 60%, a defect such as the insufficient strength of the partition walls might occur.

From a viewpoint that the conductivity be secured, the honeycomb electrode has an electric resistance of preferably 2 Ω or less, further preferably 0.3 Ω or less during the application of a voltage of 3.5 V at 180°C. To obtain such an electric resistance, a treatment for mixing silicon carbide used as the conductive ceramic material with metal silicon or forming a complex material of silicon carbide and metal silicon is preferably performed.

It is to be noted that "the electric resistance" mentioned herein is a value measured (at 180°C) in a gap of 2.3 cm between voltage terminals by a constant current 4-terminal method using a direct-current power source in a rectangular parallelepiped member which is cut along a direction in which the gas flows through the honeycomb electrode (a cell forming direction) and which has a length of 3.3 cm and a sectional area of 1.1 cm² (the sectional area of the section of the member vertical to the gas flow direction).

From the viewpoint of the activation of the loading catalyst, the honeycomb electrode has a heat transfer coefficient of preferably 10 to 300 W/mK, further preferably 10 to 200 W/mK, especially preferably 20 to 100 W/mK. When the heat transfer coefficient is less than 10 W/mK, much time might be required for activating the loading catalyst. On the other hand, when the heat transfer coefficient exceeds 300 W/mK, heat is noticeably released to the outside, and the loading catalyst might not be sufficiently activated. Examples of the conductive ceramic material having such a heat transfer coefficient include silicon carbide, silicon nitride and aluminum nitride.

The honeycomb electrode is disposed with an inter-electrode distance of preferably 1 to 30 mm, further preferably 5 to 10 mm between the honeycomb electrode and the linear electrode. When the inter-electrode distance is less than 1 mm, an electric field is easily concentrated, and short-circuit due to this concentration is easily caused sometimes. Moreover, plasma discharge across the electrodes is performed, but the amount of hydrogen generated by the reforming reaction of hydrocarbons decreases sometimes. On the other hand, when the inter-electrode distance exceeds 30 mm, the plasma discharge is not easily stabilized, and a plasma generation efficiency lowers sometimes.

### [2-1-2] Linear Electrode:

In the pair of electrodes of the plasma reactor of the present invention, the electrode other than the honeycomb electrode is the linear electrode. The "linear electrode" mentioned herein is a rod-like electrode and, for example, a needle-like electrode or the like may be used instead of the rod-like electrode. A "rod-like" shape is a linear columnar shape having a constant outer diameter in a longitudinal direction, and a "needle-like" shape is a linear shape having a pointed tip thereof. However, the shape of the linear electrode is not necessarily limited to the linear shape of the rod-like electrode or the needle-like electrode, and the linear electrode may have a bent shape such as an L-shape. As to the number of the linear electrodes to be disposed, at least one linear electrode may be disposed, or a plurality of linear electrodes may be arranged.

The length of the linear electrode is preferably 3 to 50 mm, further preferably 5 to 30 mm in order to decrease the size of the plasma reactor. When the length is less than 3 mm, during the manufacturing of the plasma reactor, the linear electrode is unstably handled, and it might be difficult to fix the linear electrode. On the other hand, when the length exceeds 50 mm, the linear electrode coming in contact with the flowing gas to be reformed might easily bend.

Moreover, the outer diameter of the linear electrode is preferably 0.1 to 5 mm, further preferably 0.5 to 3 mm. When the outer diameter is less than 0.1 mm, the linear electrode coming in contact with the flowing gas to become unstable easily bends, and the plasma discharge might be destabilized. On the other hand, when the outer diameter exceeds 5 mm, the plasma discharge might not easily be controlled.

From the viewpoint that the electric conductivity be secured, the linear electrode is preferably made of a material having a high electric conductivity, specifically a metal, an alloy, an electrically conductive ceramic material or the like. Examples of the metal having the high electric conductivity include stainless steel, nickel, copper, aluminum and iron, examples of the alloy having the high electric conductivity include an aluminum-copper alloy, a titanium alloy and Inconel (trade name), examples of the electrically conductive ceramic material include silicon carbide, and examples of another material include carbon.

### [2-1-3] Catalyst:

The plasma reactor of the present invention preferably includes the catalyst which promotes the reforming reaction of the gas to be reformed. There is not any special restriction on the use of the catalyst as long as the catalyst is a substance having the catalytic function. Examples of the catalyst include a substance containing at least one element selected from the group consisting of noble metals (platinum, rhodium, palladium, ruthenium, indium, silver and gold), aluminum, nickel, zirconium, titanium, cerium, cobalt, manganese, zinc, copper, tin, iron, niobium, magnesium, lanthanum, samarium, bismuth and barium. Examples of the configuration of the substance containing the element include a single metal, a metal oxide and another compound (chloride, sulfate or the like). These substances may be used alone or as a combination of two or more of them.

The catalyst is preferably loaded in the partition walls of the honeycomb electrode. The catalyst is loaded in the cells of the honeycomb electrode through which the gas to be reformed passes, whereby the reaction efficiency can be improved. Moreover, unlike a packed bed system in which a particulate catalyst is charged, the cells which become the through channels of the gas are secured, so that the passage of the gas to be reformed is hardly disturbed. Moreover, the catalyst components are loaded in the honeycomb electrode which becomes the loading member, and hence the heat is satisfactorily transferred across the catalysts.

The loading amount of the catalyst is preferably 0.05 to 70 g/L, further preferably 0.1 to 40 g/L. When the loading amount is less than 0.05 g/L, the catalytic function might not easily be developed. On the other hand, when the loading amount exceeds 70 g/L, the manufacturing cost of the plasma reactor might increase.

The catalyst is preferably loaded in the partition walls of the honeycomb electrode in the form of fine particles coated with the catalyst and loaded in loading fine particles. Such a configuration has an advantage that the reaction efficiency of the gas to be reformed with respect to the catalyst is improved. As the loading fine particles, for example, the ceramic powder may be used. There is not any special restriction on the type of the ceramic material, but it is possible to preferably use the powder of a metal oxide, especially silica, alumina, titania, zirconia, ceria, zeolite, mordenite, silica alumina, metal silicate, cordierite or the like. These ceramic materials may be used alone or as a combination of two or more of them. The partition walls of the honeycomb electrode can be coated with such fine particles coated with the catalyst, to load the catalyst.

The powder has an average particle diameter of preferably 0.01 to 50 µm, further preferably 0.1 to 20 µm. When the average particle diameter is less than 0.01 µm, the catalyst might not easily be loaded on the surfaces of the loading fine particles. On the other hand, when the average particle diameter exceeds 50 µm, the fine particle coated with the catalyst might easily be peeled from the honeycomb electrode.

The mass ratio of the catalyst with respect to the loading fine particles is preferably 0.1 to 20 mass%, further preferably 1 to 10 mass%. When the mass ratio of the catalyst is less than 0.1 mass%, the reforming reaction might not easily proceed. On the other hand, when the mass ratio exceeds 20 mass%, the catalyst is not uniformly dispersed but easily agglomerates, so that the catalyst is not easily uniformly loaded in the loading fine particles. Therefore, even when the amount of the catalyst exceeding 20 mass% is added, a catalyst addition effect corresponding to the amount cannot be obtained, and the reforming reaction might not be promoted.

The fine particles coated with the catalyst can be obtained by infiltrating an aqueous solution including the catalyst components into the ceramic powder which becomes the loading fine particles, followed by drying and firing. A dispersion medium (water or the like) or another additive is added to the fine particles coated with the catalyst, to prepare a coating solution (the slurry), and the partition walls of the honeycomb structure are coated with the slurry, whereby the catalyst can be loaded in the partition walls of the honeycomb structure.

### [2-1-4] Reforming Reactor:

In the present invention, the reforming reactor is a tubular structure provided with an introduction port of a gas to be reformed and a discharge port of the reformed gas. The gas needs to pass through the structure, and hence the structure needs to have a hollow shape, but there is not any special restriction on the shape of the reactor, and a structure having, for example, a cylindrical shape, a square post-like shape or the like may be used. There is not any special restriction on the maximum inner diameter of the reforming reactor, and the size of the reactor may appropriately be determined in accordance with the application of the plasma reactor.

Moreover, there is not any special restriction on the material of the reforming reactor, and a container portion is preferably made of a metal (e.g., stainless steel or the like) having satisfactory processing properties. Moreover, short-circuit needs to be prevented, and hence electrode installing portions in a container or the like are preferably made of an insulating material. Moreover, to further decrease the release of the heat, a heat insulating material may be installed around the insulating material.

As the insulating material, a ceramic material is preferably used. As the ceramic material, for example, alumina, zirconia, silicon nitride, aluminum nitride, sialon, mullite, silica, cordierite or the like is preferably used. The ceramic materials may be used alone or as a combination of two or more of them.

As the above heat insulating material, a porous ceramic material is preferably used, but there is not any special restriction on the material.

### [2-1-5] Pulse Source:

The pulse source is a power source which applies a pulse voltage to a pair of electrodes. Any power source that can periodically apply the voltage may be used. In particular, the power source can preferably supply (a) a pulse waveform having a peak voltage of 1 kV or more and one or more pulses per second, (b) an alternate-current voltage waveform having a peak voltage of 1 kV or more and a frequency of 1 or more, (c) a direct-current waveform having a voltage of 1 kV or more or (d) a voltage waveform on which one of these waveforms is superimposed. Moreover, a power source having a peak voltage of preferably 1 to 20 kV, further preferably 5 to 10 kV is used. Examples of such a power source include a high-voltage pulse source (manufactured by NGK Insulators, Ltd.) using a static induction type thyristor (SI thyristor).

### [3] Manufacturing Method:

The plasma reactor of the present invention can be manufactured as follows. The reforming reactor and the honeycomb electrode are obtained by a heretofore known extrusion method. Specifically, a clay including ceramic powder is extruded into a desired shape, dried and fired to obtain the tubular (cylindrical) reforming reactor and the honeycomb electrode having a honeycomb shape. In this case, as to the reforming reactor, an insulating material such as alumina is used. As to the honeycomb electrode, a conductive material such as silicon carbide is used as a ceramic material.

The catalyst is loaded in the partition walls of the honeycomb electrode. An aqueous solution including catalyst components is beforehand infiltrated into the ceramic powder which becomes the loading fine particles, followed by drying and firing, thereby obtaining the fine particles coated with the catalyst. A dispersion medium (water or the like) or another additive is added to the fine particles coated with the catalyst, to prepare a coating solution (the slurry), and the partition walls of the honeycomb electrode are coated with this slurry, dried and fired, whereby the catalyst is loaded in the partition walls of the honeycomb electrode.

The honeycomb electrode obtained in this manner is installed in an internal space of the reforming reactor.
In this case, the honeycomb electrode is disposed so as to face the linear electrode with a predetermined distance therebetween. Then, the honeycomb electrode and the linear electrode are electrically connected to the pulse source, whereby the plasma reactor is obtained.

### [4] Use Method:

The plasma reactor of the present invention can be used in a reforming reaction, especially in a reforming reaction in which a hydrocarbon based compound or an alcohol is used as the gas to be reformed to obtain the reformed gas containing hydrogen.

Examples of "the hydrocarbon based compound" include soft hydrocarbons such as methane, propane, butane, heptane and hexane, and petroleum hydrocarbons such as isooctane, gasoline, kerosene, light oil and naphtha. Examples of "the alcohols" include methanol, ethanol, 1-propanol, 2-propanol and 1-butanol. These gases to be reformed may be used alone or as a mixture of two or more of them.

There is not any special restriction on a reforming method. The present invention can be used in, for example, partial reforming by use of oxygen, steam reforming by use of water, an auto thermal method by use of water or any other method.

The reforming reaction can be performed by introducing the gas to be reformed into the internal space of the reforming reactor by use of the plasma reactor of the present invention, and applying, from the pulse source to the electrodes, a pulse voltage having one voltage waveform selected from (a) the pulse waveform having a peak voltage of 1 kV or more and one or more pulses per second, (b) the alternate-current voltage waveform having a peak voltage of 1 kV or more and a frequency of 1 or more, (c) the direct-current waveform having a voltage of 1 kV or more and (d) the voltage waveform on which one of these waveforms is superimposed.

### [Examples]

The present invention will more specifically be described with respect to examples, but the present invention is not limited to these examples. It is to be noted that "parts" and "%" in the following examples and comparative examples are parts by mass and mass% unless otherwise specified. Moreover, various evaluations and measurements in the examples were performed by the following methods.

### [1] Gas Temperature Rise Test:

First, a gas temperature rise test was performed. Specifically, a honeycomb structure was prepared and tested as follows.

### (Preparation of Plugged Silicon Carbide (SiC) Honeycomb Structure)

In the present example, first, a honeycomb structure was prepared which was a silicon carbide (SiC) diesel particulate filter (DPF) (manufactured by NGK Insulators, Ltd., a pitch of 1 mm) made of silicon carbide (SiC) and configured to collect a particulate material included in an engine exhaust gas or the like. In the honeycomb structure, a plurality of cells which because through channels of a gas were defined by partition walls. Next, the prepared honeycomb structure was cut out to obtain a test piece having one or two outer peripheral portion cells plugged on both sides. At this time, a plugging area with respect to the area of a gas injection port was 10% in case of one-cell plugging, and 20% in case of two-cell plugging. As to the size of the honeycomb structure, the structure had a rectangular parallelepiped shape with a vertical dimension of 20 mm, a lateral dimension of 30 mm and a length of 30 mm. A plugging material was silicon carbide (SiC) having the same composition as that of the honeycomb structure. The length of the plugging material was set to 5 mm or 10 mm from the end face of the cell structural portion. It is to be noted that Fig. 1 shows a silicon carbide (SiC) honeycomb structure whose outer peripheral portion of one cell row is plugged.

### (Examples 1 to 3)

The silicon carbide (SiC) honeycomb structure prepared in this manner and having a plugging depth of 5 mm (including air insulation) was Example 1, and the honeycomb structure having a plugging depth of 10 mm (including the air insulation) was Example 2. Moreover, the honeycomb structure whose outer peripheral portion of two cell rows was plugged in each end face thereof (a plugging depth of 5 mm, including the air insulation) was Example 3. It is to be noted that a power supplied into a flat plate heater was 50 W.

### (Comparative Example 1)

A honeycomb structure similar to the above honeycomb structures of Examples 1 to 3 was cut out to obtain, as Comparative Example 1, an unplugged silicon carbide (SiC) honeycomb structure having a rectangular parallelepiped shape with a vertical dimension of 20 mm, a lateral dimension of 30 mm and a length of 30 mm. It is to be noted that the structure was formed in the same manner as in Example 1 except that air insulation was not provided.

### (Comparative Example 2)

As Comparative Example 2, a honeycomb structure similar to the above honeycomb structures of Examples 1 to 3 was cut out to obtain a rectangular parallelepiped shape having a vertical dimension of 20 mm, a lateral dimension of 30 mm and a length of 30 mm. Furthermore, the outer peripheral portion of the structure was not completely plugged, and cells in one cell row of the outer peripheral portion of the structure were alternately plugged (on both sides). Such a silicon carbide (SiC) honeycomb structure was used as Comparative Example 2. Specifically, "a plugged portion" obtained by alternately plugging the cells (on both the sides) had a plugging depth of 5 mm, and the structure had air insulating properties.

### (Comparative Example 3)

As Comparative Example 3, a honeycomb structure similar to the above honeycomb structures of Examples 1 to 3 was cut out to obtain a rectangular parallelepiped shape having a vertical dimension of 20 mm, a lateral dimension of 30 mm and a length of 30 mm. The one-side plugged silicon carbide (SiC) honeycomb structure which was plugged on one side was used as Comparative Example 3. It is to be noted that in Comparative Example 3, the structure was plugged on the one side, and hence did not have any air insulation.

### (Comparative Example 4)

As Comparative Example 4, a honeycomb structure similar to the above honeycomb structures of Examples 1 to 3 was cut out to obtain a rectangular parallelepiped shape having a vertical dimension of 20 mm, a lateral dimension of 30 mm and a length of 30 mm. The silicon carbide (SiC) honeycomb structure in which cells were plugged and closed was used.

### (Honeycomb Structure Fixing Container)

As a container for fixing the honeycomb structures of Examples 1 to 3 and Comparative Examples 1 to 4, a container made of stainless steel was prepared. Specifically, a quadrangular post having a vertical dimension of 40 mm, a lateral dimension of 50 mm, a length of 70 mm and a thickness of 5 mm was used. In this stainless steel quadrangular post, alumina was disposed as an insulator, and each honeycomb structure was installed in this insulator.

### (Flat Plate Heater)

To raise the temperatures of the honeycomb structures of Examples 1 to 3 and Comparative Examples 1 to 4 themselves, a flat plate heater (manufactured by Sakaguchi E.H VOC CORP.) was installed on one side of each honeycomb structure. As to the size of the flat plate heater, a vertical dimension was 25 mm, a lateral dimension as 25 mm, and a thickness was 2 mm.

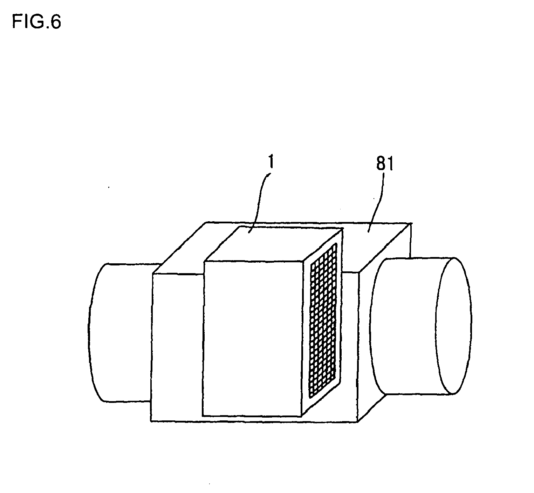

The honeycomb structures of Examples 1 to 3 and Comparative Examples 1 to 4 prepared as described above, and a honeycomb structure fixing container shown in Fig. 6 were used, and a gas temperature rise test was performed. In the test, an N₂ gas was used. The space velocity (SV) of the N₂ gas with respect to the volume of the catalyst loading plugged SiC honeycomb structure was set to 80000 h^{- 1}. A time to introduce the N₂ gas was regarded as a start time, and the temperature of the gas with respect to the time was measured. At this time, to measure the temperature of the gas, a thermocouple was installed in a position of 5 mm behind a gas outlet of the silicon carbide (SiC) honeycomb structure plugged on both sides.

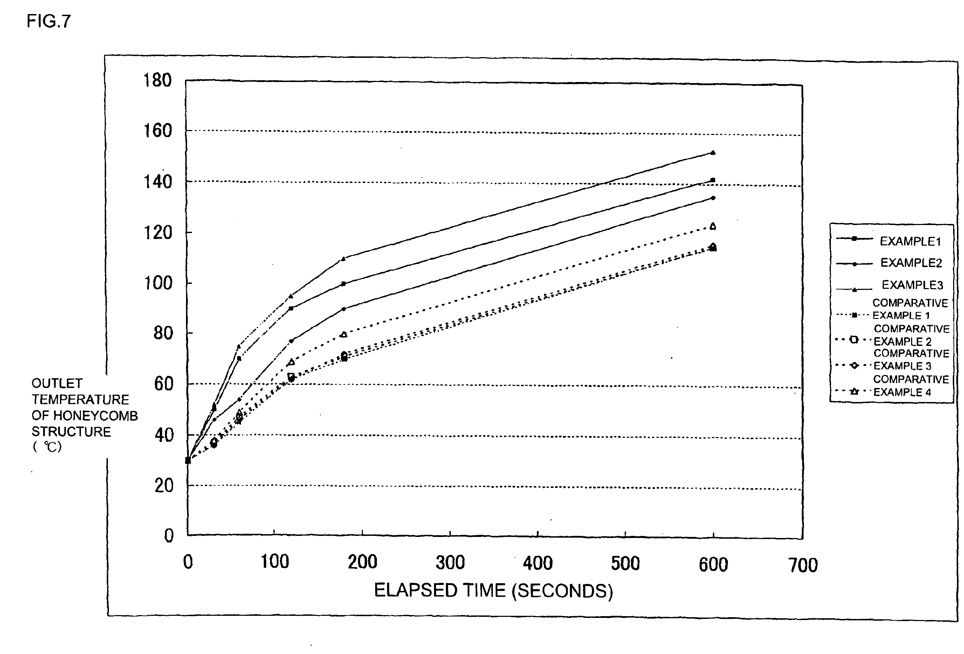

The experiment results of the above honeycomb structures of Examples 1 to 3 and Comparative Examples 1 to 4 are shown in Table 1 and Fig. 7.

**[Table 1]**

| | Elapsed time (seconds) | | | | | |
|---|---|---|---|---|---|---|
| | 0 | 30 | 60 | 120 | 180 | 600 |
| Example 1 | 30°C | 50°C | 70°C | 90°C | 100°C | 142°C |
| Example 2 | 30°C | 46°C | 54°C | 77°C | 90°C | 135°C |
| Example 3 | 30°C | 52°C | 75°C | 95°C | 110°C | 153°C |
| Comparative Example 1 | 30°C | 36°C | 45°C | 62°C | 70°C | 115°C |
| Comparative Example 2 | 30°C | 37°C | 47°C | 63°C | 71°C | 115°C |
| Comparative Example 3 | 30°C | 36°C | 46°C | 62°C | 72°C | 116°C |
| Comparative Example 4 | 30°C | 38°C | 49°C | 69°C | 80°C | 124°C |

### (Considerations)

It has been seen from Table 1 and Fig. 7 that in Examples 1 to 3, the temperature noticeably rise with respect to the elapsed time as compared with Comparative Examples 1 to 4. This is supposedly because the honeycomb structure is plugged to form an air insulating layer in the plugged portion, and accordingly the heat release from the honeycomb structure itself decreases. Moreover, as a result of comparison between Example 1 and Example 2, it has been found that in the structure having a small plugging depth at both ends thereof, that is, having a large air insulation volume, the temperature noticeably rises, and the heat release decreases. On the other hand, as a result of comparison between Example 1 and Example 3, it has been found that in Example 3, the temperature more noticeably rises. This indicates that the plugged cells increase, whereby the air insulation volume increases, and an insulating effect further improves. It is considered that in the comparative examples, any air insulating layer is not formed, or the air insulating layer is insufficiently formed, and hence the insulation of the honeycomb structure itself is poor, whereby the temperature rises of the examples cannot be recognized.

### [2] Silicon Carbide Reforming Test by Plasma Discharge:

Next, a silicon carbide reforming test by plasma discharge was performed. Specifically, the test was performed as follows.

### (Preparation of Catalyst Loading Plugged Silicon Carbide (SiC) Honeycomb Structure)

A nickel nitrate (Ni(NO₃)₂) solution was infiltrated into fine alumina powder (a specific surface area of 107 m²/g), followed by drying at 120°C and then firing in the atmosphere at 550°C for three hours, to obtain the Ni/alumina powder containing 20 wt% of nickel (Ni) with respect to alumina. After adding alumina sol and water to the powder, the resultant material was regulated to pH4 with a nitric acid solution to obtain a slurry. In the slurry, the plugged silicon carbide (SiC) honeycomb structure was immersed, dried at 120°C, and fired in a nitrogen atmosphere at 550°C for one hour, to prepare a catalyst loading silicon carbide (SiC) honeycomb structure plugged on both sides (a plugging depth of 5 mm). At this time, the amount of Ni loaded in the plugged silicon carbide (SiC) honeycomb structure was 50 (g/L).

### (Plasma Generation Power Source)

As a plasma generation power source, a high-voltage pulse power source (manufactured by NGK Insulators, Ltd.) using a static induction type (SI) thyristor as a switching element was used.

### (Linear Electrode)

As a linear electrode, an electrode made of stainless steel and having a diameter of 0.5 mmΦ and a length of about 10 mm was used. As another material, an anti-corrosion conductive material including Inconel or the like can be used. The linear electrode was used on the side of a positive pole. It is to be noted that the tip of the linear electrode does not have to be pointed as in a needle, and the linear electrode may have a rod-like shape, a plate-like shape or the like. There is not any special restriction on the shape of the electrode.

### (Plasma Reactor)

As a container, a cylindrical member made of stainless steel and having an inner diameter of 30 mm, a thickness of 5 mm and a length of 70 mm was used. In this stainless steel cylindrical member, alumina was disposed as an insulator, and a catalyst loading plugged silicon carbide (SiC) honeycomb structure was installed in the insulator. The linear electrode, the catalyst loading plugged silicon carbide (SiC) honeycomb structure (also used as an electrode) and a plasma generation electrode were arranged as shown in Fig. 8, and the plasma generation (pulse) power source was electrically connected to the linear electrode (the positive electrode) and the catalyst loading plugged SiC honeycomb structure (the negative electrode) via a conductive wire. The linear electrode (the positive electrode) was disposed with a space of 5 mm from the end of the catalyst loading plugged SiC honeycomb structure (the negative electrode) on an inlet side thereof. When the distance of the linear electrode (the positive electrode) is larger than 0 mm and smaller than 5 mm, plasma discharge across the electrodes is performed, but the amount of hydrogen generated during the reforming reaction of hydrocarbons decreases. Therefore, the distance of the linear electrode is more preferably 5 mm or more and 10 mm or less. Even when the distance between the electrodes is larger than 10 mm, hydrocarbons can be reformed, but the plasma discharge is not easily stabilized, and hence it can be considered that the above range is preferable.

### (Constituent Members of Plasma Reactor)

The constituent members of the plasma reactor are the honeycomb structure (also used as the electrode in the example: the negative electrode), the linear electrode (the positive electrode), the catalyst, the reforming reactor, the pulse source and the like. Moreover, when the honeycomb structure is used as the electrode, silicon carbide is preferable as "the conductive ceramic material". However, the honeycomb structure itself does not have to be made of silicon carbide, as long as the honeycomb structure has a conductivity. That is, in the plasma reactor, the honeycomb structure is preferably made of a conductive ceramic material including silicon carbide. In this case, the content of silicon carbide in the honeycomb structure is preferably 50 mass% or more, further preferably 60 mass% or more in order to suppress the lowering of the conductivity.

### (Example 4)

As Example 4, the reforming test of hydrocarbons was performed by using the plasma reactor shown in Fig. 8. At this time, isooctane (i-C₈H₁₈) was used as the hydrocarbon. A reforming method was partial oxidizing reaction of i-C₈H₁₈. This i-C₈H₁₈ was a liquid. Therefore, a gas to be introduced into the plasma reactor was beforehand heated to 250°C, and the regulated amount of i-C₈H₁₈ was injected into the gas and evaporated by use of a high-pressure micro feeder (JP-H type manufactured by IPROS CORPORATION). As a model gas, a gas made of i-C₈H₁₈: 2000 ppm, O₂: 16000 ppm and a balance of an N₂ gas was used. At this time, the space velocity (SV) of the model gas was set to 80000 h⁻¹ with respect to the plasma generation space in the catalyst loading plugged SiC honeycomb electrode. The model gas was introduced into the plasma reactor, and the amount of H₂ in the discharged gas was measured with a gas chromatography (GC, GC3200 manufactured by GL Science K.K., an argon gas was used as a carrier gas) including a thermal conduction detector (TCD) to calculate an H₂ generation ratio. It is to be noted that the condition of the pulse source for generating plasmas was a repetition cycle of 3 kHz, and a peak voltage of 3 kV was applied across the electrodes. Moreover, the plasma reactor was installed in an electric furnace, and the temperature was adjusted to set the temperature in a plasma reactor main body to 600°C.

H₂ generation ratio (%) = the amount of i-C₈H₁₈ calculated from the amount of generated H₂/the amount of i-C₈H₁₈ in the model gas (Equation 1)

Moreover, a hydrogen generation experiment was performed on the same conditions by use of a catalyst loading unplugged SiC honeycomb structure.

In the present example, a columnar type was evaluated, but there is not any special restriction on the shape of the plasma reactor as long as the plasma reactor is constituted of the linear electrode (the positive electrode), the plugged silicon carbide (SiC) honeycomb structure (the negative electrode) and the pulse source.

### (Comparative Example 4)

As Comparative Example 4, a plasma reactor using a pair of linear electrodes was prepared in which instead of a catalyst loading unplugged SiC honeycomb structure (the negative electrode), a similar linear electrode was installed. Moreover, a reforming test of i-C₈H₁₈ was performed on the same conditions as those of the present example. At this time, a distance between the electrodes was set to 5 mm.

The results of the generation ratio of hydrogen generated in Example 4 and Comparative Example 4 are shown in Table 2 as follows.

**[Table 2]**

| | Example 4 | Comparative Example 4 |
|---|---|---|
| H₂ generation ratio (%) | 78 | 69 |

In Example 4, a high hydrogen generation ratio was indicated as compared with Comparative Example 4. It has been seen from these results that when the outer peripheral portion of the honeycomb structure on both sides is plugged, the insulation properties of the honeycomb structure itself improve, and hydrogen is efficiently generated from iso-C₈H₁₈.

As seen from the above results, when the honeycomb structure including the plugged cells of the outer peripheral portion on both sides thereof is used as in the present invention, the insulating properties of the structure itself improve. When the structure is used in a reactor reacting portion, a more efficient reactor can be provided as compared with a conventional technology.

The plasma reactor of the present invention can preferably be used for the reforming reaction of a hydrocarbon compounds or alcohols, especially a hydrogen generating reaction. Moreover, a large amount of reformed gas can stably be supplied over a long time, and hence the present invention can preferably be used for the application of a car-mounted fuel reformer or the like.

## Claims

1. A honeycomb structure comprising:
a cell structural portion having partition walls which connect one end face thereof to the other end face thereof to define a plurality of cells as through channels of a gas; and
cells having plugging portions which plug both the end faces of an outer peripheral portion of the cell structural portion,
wherein the cell area of the plugging portions is 10% or more of the whole cell area.

2. The honeycomb structure according to claim 1, wherein the length of each plugging portion in a cell direction is shorter than the whole length of each cell.

3. The honeycomb structure according to claim 1 or 2, wherein the length of the plugging portion in the cell direction is 1/6 to 1/3 of the whole length of each cell.

4. The honeycomb structure according to any one of claims 1 to 3, whose main component is a ceramic material or a metal material.

5. The honeycomb structure according to claim 4, wherein the ceramic material includes silicon carbide.

6. The honeycomb structure according to any one of claims 1 to 5, wherein a catalyst is loaded.

7. A plasma reactor which is provided with a honeycomb electrode using the honeycomb structure according to any one of claims 1 to 6, the reactor comprising: a reforming reactor provided with an introduction port of a gas to be reformed and a discharge port of the reformed gas; a pair of electrodes arranged so as to face each other in an internal space of the reforming reactor; and a pulse source which applies pulse voltages to the pair of electrodes,
wherein one of the pair of the electrodes is a linear electrode, and
the other electrode thereof is made of a conductive ceramic material.

8. The plasma reactor according to claim 7, wherein a catalyst is loaded in the honeycomb structure.

9. The plasma reactor according to claim 8, wherein the catalyst is a catalyst which promotes the reforming reaction of the gas to be reformed, and is loaded in the partition walls of the honeycomb electrodes.

10. The plasma reactor according to claim 8 or 9, wherein the catalyst is made of a substance containing at least one element selected from the group consisting of a noble metal, aluminum, nickel, zirconium, titanium, cerium, cobalt, manganese, zinc, copper, tin, iron, niobium, magnesium, lanthanum, samarium, bismuth and barium.

11. The plasma reactor according to any one of claims 8 to 10, wherein the catalyst is a substance containing at least one element selected from the group consisting of platinum, rhodium, palladium, ruthenium, indium, silver and gold.

12. The plasma reactor according to any one of claims 7 to 11, wherein the honeycomb electrode is made of a conductive ceramic material including silicon carbide.

13. The plasma reactor according to any one of claims 7 to 12, wherein the honeycomb electrode has a heat transfer coefficient of 10 to 300 W/mK.

14. The plasma reactor according to any one of claims 7 to 13, wherein the pulse source is a high voltage pulse source using an electrostatic induction type thyristor.
